# EUROPÄISCHE PATENTSCHRIFT

(11) **EP 2 739 477 B1**
(45) Veröffentlichungstag und Bekanntmachung des Hinweises auf die Patenterteilung: **03.12.2014**
(21) Anmeldenummer: 12747881.6
(22) Anmeldetag: 27.06.2012
(51) Int. Cl.: B41F 17/00, H05B 3/30, H05B 3/28, B44B 5/02, B44C 1/17, B29C 33/02, B29C 43/52

(54) **MIKROSTRUKTURIERTER HEISSPRÄGESTEMPEL**
MICROSTRUCTURED HOT EMBOSSING STAMP
MATRICE D'ESTAMPAGE A CHAUD COMPORTANT DES MICROSTRUCTURES

(30) Priorität: 02.08.2011 DE 102011052365
(43) Veröffentlichungstag der Anmeldung: 11.06.2014
(73) Patentinhaber: Heraeus Sensor Technology GmbH, 63450 Hanau (DE)
(72) Erfinder: WIENAND, Karlheinz, 63741 Aschaffenburg (DE); ZINKEVICH, Matsvei, 63773 Goldbach (DE)
(74) Vertreter: Schultheiss & Sterzel Patentanwälte PartG mbB
(86) Internationale Anmeldenummer: PCT/EP2012/002707
(87) Internationale Veröffentlichungsnummer: WO 2013/017185

(56) Entgegenhaltungen:
- DE-A1- 3 325 310
- DE-A1- 3 829 297
- DE-A1- 19 942 364
- US-A- 4 886 630
- DATABASE WPI Week 199224 Thomson Scientific, London, GB; AN 1992-196877 XP002689578, -& JP 4 129711 A (SUMITOMO HEAVY IND LTD) 30. April 1992 (1992-04-30)
- DATABASE WPI Week 200445 Thomson Scientific, London, GB; AN 2004-471094 XP002689579, -& JP 2004 148398 A (DAINIPPON PRINTING CO LTD) 27. Mai 2004 (2004-05-27)

## Beschreibung

Die Erfindung betrifft einen Prägestempel zum Heißprägen eines Materials umfassend eine profilierte Prägeoberfläche.

Die Erfindung betrifft auch ein Verfahren zum Heißprägen eines Materials mit einem solchen Prägestempel und ein Verfahren zur Herstellung eines solchen Prägestempels.

Zur Umformung, Beschriftung und Kennzeichnung verschiedener Materialien, insbesondere von Kunststoffen, kommen Heißprägeverfahren zum Einsatz. Das Material wird dabei oxidiert, umgeformt oder pyrolisiert.

Aus der DE 10 2004 025 568 A1 ist eine Vorrichtung zum Prägen einer Folie während eines Tiefziehprozesses bekannt, die einen positiven Prägestempel umfasst. Der Prägestempel ist beheizbar, um eine einwandfreie Prägung ohne Verzerrung oder Beschädigung der Folie zu erreichen.

Die DE 38 29 297 A1 offenbart einen Prägestempel mit Widerstandsmetallbahnen auf einer Leiterplatte als Heizvorrichtung, auf der ein profilierter Stempelkörper aus einer Gummimischung angeordnet ist. Die Anordnung ist mit einem Druckkissen unterfüttert. Der Aufbau ist voluminös, wobei letztendlich das gesamte Volumen beheizt werden muss, und zudem durch den weichen Aufbau nur für bestimmte Anwendungen einsetzbar. Aus der DE 199 42 364 A1 ist ein Stempelkörper bekannt, der ein Heizelement aus einer Mehrphasen-Matrix-Keramik aufweist.

Die WO 03/049 915 A1 offenbart ein beheizbares Heißprägewerkzeug zur Mikrostrukturierung eines thermoplastischen Werkstoffs in einem kontinuierlichen Verfahren. Das Heißprägewerkzeug wird aus Segmenten zusammengelötet, wobei das Lot andere Materialeigenschaften als die Segmente hat. Die Prägung erfolgt bei einer Temperatur, die oberhalb der Glasübergangstemperatur des zu prägenden Kunststoffs liegt. Gleichzeitig wird ein Druck aufgebracht, wobei die zu prägende Folie unter Druck abgekühlt wird.

Solche beheizbaren Prägestempel sind üblicherweise aus Metall gefertigt und werden mit Heizpatronen oder Gasbrennern extern beheizt.

Nachteilig ist hieran, dass zumindest der gesamte Prägestempel beheizt werden muss, wodurch entsprechend viel Energie aufgewendet werden muss. Zudem wären, insbesondere bei einer Beschriftung, scharfe Begrenzungen der geprägten Formen wünschenswert. Beim Einbau solcher beheizbaren Prägestempel muss zudem dessen hohe Temperatur und die thermische Belastung des Einbauorts beachtet werden. Bei einem Hautkontakt mit Teilen des Prägestempels oder der Bereiche in der Nähe kann es zu Verbrennungen kommen. Je größer die Wärmekapazität des beheizten Prägestempels ist, desto mehr Zeit wird benötigt, bis der Prägestempel so weit abgekühlt ist, dass ein Ausbau oder Wechsel gefahrlos erfolgen kann. Um beim Prägen eine Kühlung zu erreichen, muss der Prägestempel entweder aktiv gekühlt werden oder es muss eine ausreichende Zeit abgewartet werden, bis der Prägevorgang abgeschlossen worden ist.

Die Aufgabe der Erfindung besteht also darin, die Nachteile des Stands der Technik zu überwinden. Insbesondere soll ein energiesparendes Heißprägen ermöglicht werden. Gleichzeitig soll eine scharfe Kontur der geprägten Form erzeugbar sein. Ein gefahrloser Umgang mit dem Prägestempel soll auch nach dem Gebrauch sichergestellt sein. Auch wäre eine schnelle Reaktionszeit bei Temperaturveränderungen des Prägestempels vorteilhaft.

Die Aufgabe der Erfindung wird dadurch gelöst, dass der Prägestempel zumindest ein wärmeisolierendes Substrat umfasst, auf der eine elektrisch leitende Struktur umfassend einen Heizwiderstand angeordnet ist, und wobei die elektrisch leitende Struktur mit einer elektrisch isolierenden Schicht abgedeckt ist, wobei die Oberfläche der elektrisch isolierenden Schicht die profilierte Prägeoberfläche umfasst und die elektrisch isolierende Schicht zumindest den Heizwiderstand abdeckt, so dass die elektrisch isolierende Schicht mit der Prägeoberfläche durch den Heizwiderstand elektrisch beheizbar ist und wobei das wärmeisolierende Substrat (2, 12) eine oxydische Keramik und/oder ein Metalloxid ist und das wärmeisolierende Substrat (2, 12) eine Wärmeleitfähigkeit kleiner als 5 W / (m K) hat.

Unter einem Heizwiderstand ist vorliegend ein Bereich der elektrisch leitenden Struktur zu verstehen, an dem, beim Anlegen einer elektrischen Spannung an der elektrisch leitenden Struktur beziehungsweise an deren Anschlüssen, ein Großteil der elektrischen Spannung abfällt. Gleichzeitig wird dadurch dort dann die meiste Wärme erzeugt.

Dabei kann vorgesehen sein, dass der Prägestempel als Sandwichstruktur aufgebaut ist, wobei die elektrisch leitfähige Struktur zwischen dem wärmeisolierenden Substrat und der elektrisch isolierenden Schicht angeordnet ist.

Eine Sandwichstruktur hat den Vorteil, dass die elektrisch leitfähige Struktur in der Mitte gut geschützt ist.

Auch kann erfindungsgemäß vorgesehen sein, dass die elektrisch leitende Struktur zwei Leitungen umfasst, über die der Heizwiderstand elektrisch kontaktierbar ist.

Durch die Trennung zwischen dem Heizwiderstand und den Zuleitungen kann sichergestellt werden, dass der Heizbereich durch die elektrisch isolierende Schicht komplett abgedeckt wird, während Teile der Leitung freiliegen können. Zudem kann für die Leitungen ein kostengünstigeres Material gewählt werden.

Dabei kann wiederum vorgesehen sein, dass die Leitungen einen größeren Leitungsquerschnitt als der Heizwiderstand aufweisen, besonders bevorzugt einen zumindest doppelt so großen Leitungsquerschnitt.

Dadurch wird sichergestellt, dass die Spannung am Heizwiderstand abfällt und sich die Zuleitungen nicht oder nur sehr gering erwärmen.

Ferner kann dabei vorgesehen sein, dass die Leitungen zumindest bereichsweise oder im Wesentlichen von der elektrisch isolierenden Schicht bedeckt sind und/oder die Leitungen aus Kupfer und/oder Silber bestehen.

Die Leitungen können, bis auf die Teile zum Anschließen des Prägestempels, wie beispielsweise Anschlusskontaktfelder oder Stecker, durch die elektrisch isolierende Schicht abgedeckt sein. Dies schützt auch die Leitungen vor schädlichen mechanischen Einflüssen und ist daher erfindungsgemäß bevorzugt.

Eine Weiterbildung der Erfindung kann vorsehen, dass der Heizwiderstand mäanderförmig ausgebildet ist.

Es kann dabei ferner vorgesehen sein, dass beim Heizen des Prägestempels ein Großteil des Temperaturgradienten, insbesondere zumindest 70%, vorzugsweise zumindest 90%, im Bereich der Leitungen abfällt.

Besonders bevorzugt kann bei erfindungsgemäßen Prägestempeln auch vorgesehen sein, dass die elektrisch leitende Struktur eine metallische Struktur ist, insbesondere eine metallische Dickschicht ist, wobei bevorzugt der Heizwiderstand aus Platin oder Iridium besteht.

Eine Dickschicht aus Platin oder Iridium kann sehr heiß werden und ist trotzdem gegen den Sauerstoff, der in vielen Keramiken oder anderen Isolatoren enthalten ist, auch bei hohen Temperaturen chemisch stabil.

Es kann erfindungsgemäß ferner vorgesehen sein, dass die elektrisch leitende Struktur 5 µm bis 50 µm dick ist, vorzugsweise 10 µm bis 20 µm dick ist.

Dicken in diesen Bereichen sind gut für Heizwiderstände verwendbar.

Besonders bevorzugt werden erfindungsgemäß Prägestempel, bei denen das wärmeisolierende Substrat eine Wärmeleitfähigkeit kleiner als 2 W / (m K) hat, besonders bevorzugt eine Wärmeleitfähigkeit kleiner als 1 W / (m K).

Die Unterschreitung dieser Wärmeleitfähigkeit führt dazu, dass die Wärme zum Einen im zur Prägung verwendeten vorderen Bereich des Prägestempels zur Verfügung steht und zum Anderen die restlichen Bereiche des Prägestempels nicht zu heiß werden, wodurch der Einbau und Anschluss erleichtert wird und das Verletzungsrisiko verringert wird.

Gemäß einer weiteren Ausgestaltung der Erfindung kann vorgesehen sein, dass das wärmeisolierende Substrat ein Metalloxid eines drei- bis fünfwertigen Nebengruppenmetalls ist, besonders bevorzugt ein Titanat, eine Yttriumoxid stabilisierte Zirkonoxid-Keramik (YSZ) oder eine MgTiO₃-Keramik.

Diese Materialien sind besonders gut zur Realisierung eines erfindungsgemäßen Prägestempels geeignet, da sie eine hohe mechanische Stabilität und gleichzeitig eine geringe Wärmeleitfähigkeit haben.

Eine besonders geeignete Ausführungsform der Erfindung kann vorsehen, dass zwischen dem wärmeisolierenden Substrat, insbesondere dem YSZ-Substrat und der elektrisch leitfähigen Struktur eine keramische Dünnschicht angeordnet ist, die die elektrisch leitfähige Struktur von dem wärmeisolierenden Substrat elektrisch isoliert, wobei die keramische Dünnschicht bevorzugt aus einem Metalloxid besteht, besonders bevorzugt aus einer oxydischen Keramik zwei- oder dreiwertiger Hauptgruppenmetalle, ganz besonders bevorzugt aus Aluminiumoxid.

Das YSZ beginnt ab einer Temperatur von ca. 300° C derart elektrisch leitfähig zu werden, dass eine elektrische Isolation zwischen der elektrisch leitfähigen Struktur und dem YSZ-Substrat sinnvoll ist. Insbesondere also, wenn das Substrat eine höhere elektrische Leitfähigkeit bei den im Prägestempel erreichbaren Temperaturen entwickelt und/oder der Prägestempel bei hohen Temperaturen betrieben werden soll, ist eine solche elektrisch isolierende Dünnschicht besonders vorteilhaft. Die Zwischenschicht kann aber auch alternativ oder zusätzlich zur stärkeren mechanischen Anbindung der elektrisch leitfähigen Struktur an das Substrat dienen.

Bei einem Prägestempel mit Zwischenschicht kann erfindungsgemäß vorgesehen sein, dass die Zwischenschicht einen spezifischen elektrischen Widerstand von mindestens 10⁶ Ω m hat, bevorzugt einen spezifischen elektrischen Widerstand von mindestens 10⁸ Ω m, besonders bevorzugt einen spezifischen elektrischen Widerstand mindestens 10¹⁰ Ω m.

Es kann erfindungsgemäß vorgesehen sein, dass das Substrat mit einer elektrisch isolierenden keramischen Dünnschicht auf Basis einer oxydischen Keramik zwei oder dreiwertiger Hauptgruppenmetalle, insbesondere aus MeO, Me₃O₄ oder Me₂O₃, zum Beispiel aus Al₂O₃ beschichtet ist.

Ferner kann vorgesehen sein, dass die elektrisch isolierende Schicht aus Glas oder einer Glaskeramik besteht.

Das Glas oder die Glaskeramik lässt sich besonders gut Strukturieren und ist ein guter elektrischer Isolator. Daher lässt sich die Profilierung der Oberfläche mit Glas oder Glaskeramik besonders gut bewerkstelligen.

Des Weiteren kann vorgesehen sein, dass die elektrisch isolierende Schicht zwischen 1 µm und 500 µm dick ist, bevorzugt zwischen 10 µm und 100 µm dick ist, besonders bevorzugt 30 µm dick ist.

Eine weitere Ausgestaltung der Erfindung kann vorsehen, dass der Heizwiderstand mit zwei Anschlusskontaktfeldern oder zwei Anschlusssteckern elektrisch verbunden ist, vorzugsweise an jeder Leitung ein Anschlusskontaktfeld oder ein Anschlussstecker an dem vom Heizwiderstand gegenüberliegenden Ende der Leitungen angeordnet ist.

Des Weiteren kann vorgesehen sein, dass der Heizwiderstand die Hälfte bis ein Drittel der Breite der elektrisch leitenden Struktur ausmacht und/oder der Heizwiderstand nach Art einer Spitze ausgebildet ist.

Bei diesen Geometrien kann die Wärme besonders gut auf die prägende strukturierte Oberfläche konzentriert werden. Der Beriech der Anschlüsse bleibt dann besonders kühl.

Es kann erfindungsgemäß auch vorgesehen sein, dass das Substrat eine Substratlänge von 5 bis 50 mm, insbesondere von 10 bis 40 mm, besonders bevorzugt von 20 bis 30 mm hat, eine Substratbreite von 0,5 bis 20 mm, insbesondere von 2 bis 10 mm, besonders bevorzugt von 3 bis 5 mm hat und/oder eine Substratdicke von 0,1 bis 2 mm, insbesondere von 0,3 bis 1 mm, besonders bevorzugt von 0,4 bis 0,6 mm hat.

Dabei ist zu beachten, dass zu kurze und zu dicke Substrate keine ausreichenden Temperaturunterschiede beziehungsweise Temperaturgradienten liefern. Auf zu schmalen Substraten wird der Auftrag des Heizwiderstands schwierig. Zu dünne Substrate sind mechanisch instabil.

Die Breite der elektrisch leitenden Struktur erstreckt sich entlang der Substratlänge, ohne dass sie diese auf der gesamten Länge überdeckt.

Erfindungsgemäße Prägestempel können vorzugsweise mindestens doppelt so lang wie breit sein (bezogen auf das Substrat), vorzugsweise 3 bis 5 mal so lang wie breit. Ferner können erfindungsgemäße Prägestempel können vorzugsweise mindestens 10 mal so lang wie dick sein, vorzugsweise 30 bis 50 mal so lang wie dick.

Es kann auch vorgesehen sein, dass im Verbindungsbereich, in dem die elektrisch leitfähige Struktur von außen mit Drähten kontaktiert ist, die Verbindung der Drähte mit der elektrisch leitenden Struktur zugentlastet ist, vorzugsweise mit einem Glastropfen zugentlastet ist.

Die Aufgabe der Erfindung wird auch gelöst durch ein Verfahren zum Heißprägen eines Materials mit einem solchen Prägestempel bei dem der Heizwiderstand auf eine Temperatur zwischen 100° C und 800° C, vorzugsweise zwischen 200° C und 600° C, besonders bevorzugt zwischen 300° C und 400° C geheizt wird.

Bei diesen Temperaturen ist eine ausreichende Heißprägung auf vielen Materialien, insbesondere organischen Materialien gegeben.

Dabei kann vorgesehen sein, dass ein organisches Material zumindest bereichsweise bei einer Temperatur zwischen 100° C und 600° C im Bereich der profilierten Oberfläche des Prägestempels zersetzt wird, insbesondere pyrolisiert und/oder oxidiert wird.

Es kann auch vorgesehen sein, dass sich beim Heizen des Prägestempels ein Temperaturgradient einstellt, bei dem mehr als die Hälfte der Temperaturdifferenz zwischen der Temperatur im Bereich des Heizwiderstands und der Umgebungstemperatur, vorzugsweise der Raumtemperatur, im Bereich des Heizwiderstands abfällt, vorzugsweise mehr als 90%, so dass das dem Heizwiderstand gegenüberliegende Ende des Prägestempels eine Temperatur von unter 50° C aufweist, vorzugsweise eine Temperatur von unter 40° C.

Die Einstellung eines Temperaturgradienten im Prägestempel ist wesentlich dafür, dass der Prägestempel nicht an allen Oberflächen heiß wird. Nur dadurch kann der Schutz des Bedieners und die einfache Einbauweise zuverlässig realisiert werden.

Die Aufgabe der Erfindung wird schließlich auch gelöst durch ein Verfahren zur Herstellung eines Prägestempels, bei dem
A) ein wärmeisolierendes Substrat bereitgestellt wird, wobei das wärmeisolierende Substrat eine oxydische Keramik und/oder ein Metalloxid ist und das wärmeisolierende Substrat eine Wärmeleitfähigkeit kleiner als 5 W / (m K) hat,
B) auf dem wärmeisolierenden Substrat eine elektrisch leitende Struktur umfassend einen Heizwiderstand aufgebracht wird, insbesondere mit einem Dickschicht-Verfahren, besonders bevorzugt aufgedruckt wird, und
C) die elektrisch leitende Struktur zumindest bereichsweise mit einer elektrisch isolierenden Schicht mit einem Siebdruck-Verfahren oder einer Dickschicht-Technik abgedeckt wird.

Dabei kann vorgesehen sein, dass vor Schritt B) eine elektrisch isolierende Zwischenschicht auf dem wärmeisolierenden Substrat aufgebracht wird, so dass bei Schritt B) die elektrisch leitende Struktur auf der isolierenden Zwischenschicht auf dem wärmeisolierenden Substrat aufgebracht wird, wobei die Zwischenschicht, vorzugsweise mit einem Dünnschicht-Verfahren, besonders bevorzugt mit PVD aufgebracht wird.

Ferner kann vorgesehen sein, dass auf dem Substrat im mittleren Drittel des in Dickschichttechnik aufgetragenen Heizwiderstands mit ebenfalls in Dickschichttechnik aufgetragenen Leitungen verbunden werden.

Hierzu kann vorgesehen sein, dass die Leitungen als Paste auf die beiden Enden des Heizwiderstands aufgetragen und eingebrannt werden. Die Enden des Heizwiderstands sind vorzugsweise als Kontaktfelder ausgebildet.

Der Erfindung liegt die überraschende Erkenntnis zugrunde, dass es mit einem geschichteten Aufbau des Prägestempels gelingt, die für die Heißprägung notwendige Wärme gezielt in dem Bereich des Prägestempels abzugeben, der die profilierte Oberfläche zur Prägung des Materials umfasst. Die elektrische Leistung kann dazu genau im Bereich eines Heizelements verbraucht werden. Das Heizelement lässt sich, insbesondere unter Verwendung von Zuleitungen, in einer beliebigen Position des Prägestempels anordnen. Durch die wärmeisolierenden Eigenschaften des Substrats bleiben die vom Heizelement entfernten Bereiche des Prägestempels kälter, bis hin zu einer Temperatur, dicht bei der Umgebungstemperatur.

Die elektrische Leistung wird größtenteils zur Aufnahme in das zu prägende Material eingebracht. Dadurch wird der Verbrauch an elektrischer Energie durch den Prägestempel deutlich reduziert. Gleichzeitig kühlt der erfindungsgemäße Prägestempel schnell ab, so dass er nach kürzerer Zeit wieder gefahrlos ausgewechselt werden kann.

Ein wesentlicher Aspekt der vorliegenden Erfindung ist, dass der Temperaturgradient hauptsächlich dicht bei dem Heizwiderstand abfällt. Dies wird maßgeblich auch dadurch erreicht, dass die Leitungen zum Heizwiderstand (vorliegend auch Zuleitungen genannt) einen größeren Querschnitt als die elektrischen Leitungen des Heizwiderstands haben. Dadurch ist der elektrische Widerstand des Heizwiderstands wesentlich höher als der der Zuleitungen. Dadurch fällt ein Großteil der elektrischen Spannung am Heizwiderstand ab, wodurch die Temperatur des Heizwiderstands deutlich höher ist, als die der Zuleitungen. Alternativ oder zusätzlich kann die Länge der elektrischen Leitung des Heizwiderstands dadurch relativ zu den Zuleitungen groß gewählt werden, dass der Heizwiderstand in Mäandern verläuft. Auch dadurch fällt ein Großteil der elektrischen Spannung am Heizwiderstand ab, mit den geschilderten Folgen.

Der durch die erfindungsgemäßen Maßnahmen genau definierte Heizbereich ermöglicht eine Wärmeübertragung mit hoher Auflösung und mit besonders geringem Wärmeverlust gegenüber einer externen Heizquelle. Die hohe Härte des keramischen Substrats und dessen Beständigkeit gegen Oxidation sorgt für eine längere Lebensdauer gegenüber metallischen Heißprägestempeln. Auch aufwendige Gravurarbeiten können so eingespart werden.

Im Folgenden werden Ausführungsbeispiele der Erfindung anhand von zwei schematisch dargestellten Figuren erläutert, ohne jedoch dabei die Erfindung zu beschränken. Dabei zeigt:
- Figur 1:: eine schematische perspektivische Ansicht eines erfindungsgemäßen Prägestempels in Explosionsdarstellung; und
- Figur 2:: eine schematische Querschnittansicht eines alternativen erfindungsgemäßen Prägestempels.

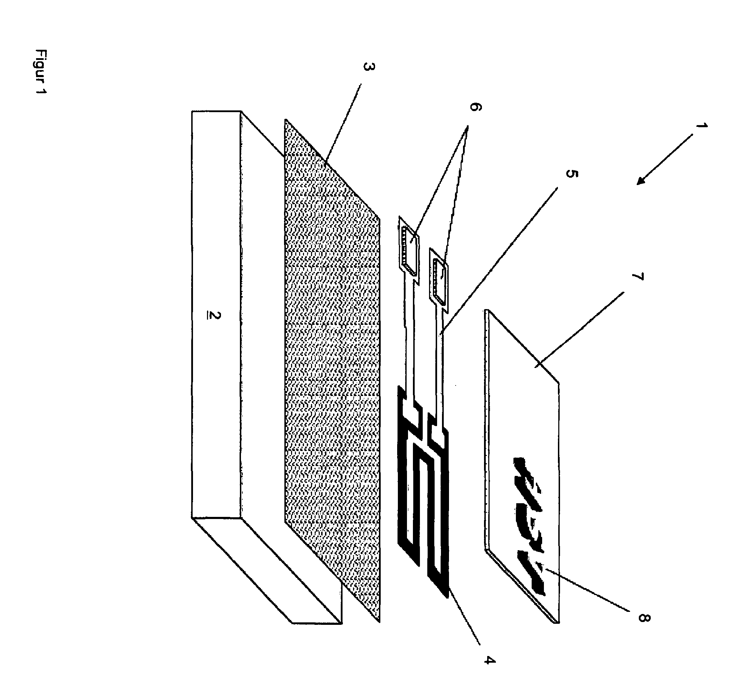

Figur 1 zeigt eine schematische perspektivische Ansicht eines erfindungsgemäßen Prägestempels 1 in Explosionsdarstellung. Der Prägestempel 1 umfasst ein Substrat 2 aus Yttrium-stabilisiertem Zirkonoxid (YSZ). Das Substrat 2 hat Abmessungen von 25 x 2 x 0,4 mm³. Das YSZ-Substrat 2 wird mit einer Dünnschicht 3 aus Al₂O₃ beschichtet. Die Beschichtung erfolgt mit Hilfe eines PVD-Verfahrens (Physical Vapour Deposition). Prinzipiell wäre auch ein anderes Dünnschichtverfahren zur Herstellung der Dünnschicht 3 denkbar, wie beispielsweise Chemische Gasphasenabscheidung (CVD), Sputtern oder ähnliches.

Auf diese keramische Dünnschicht 3 wird eine Ir-Paste oder eine Pt-Paste gedruckt und zu einer mäanderförmigen 15 µm dicken Widerstandsstruktur 4 gebrannt, die den Heizwiderstand 4 bildet. Die Widerstandsstruktur 4 endet an je einem Kontaktfeld, an dem je eine aus Silberpaste gebrannte 12 mm lange Leitung 5 angeschlossen wird. Die Leitungen 5 werden am Substratende zu Anschlusskontaktfeldern 6 verbreitert, um den Prägestempel 1 auf einer Leiterplatte aus Kunststoff (nicht gezeigt) elektrisch anzuschließen und mechanisch zu befestigen. Die elektrische Kontaktierung erfolgt durch Anlöten, Anschweißen oder Verbinden mit Drähten (nicht gezeigt), die wiederum durch Löten oder Schweißen mit der Platine und den Anschlusskontaktfeldern 6 verbunden sind. Als mechanischer Schutz und zur Zugentlastung können die Kontaktierungen mit einem Glastropfen oder einem Kunstharztropfen oder ähnlichem Zugentlastet werden.

Auf den Heizwiderstand 4 und die Leitungen 5 wird mit einer Glaspaste eine Dickschicht 7 mit einer Profilierung 8 in Form eines Reliefs als Muster 8 oder Beschriftung 8 gebrannt. Diese Glasschicht 7 schützt den Heizwiderstand 4 und dessen Leitungen 5, insbesondere während des Heißprägevorgangs.

Zum Schmelzen oder Zersetzen organischen Materials wird der Heizwiderstand 4 auf 300 bis 500° C erhitzt, so dass die Außentemperatur des Prägestempels 1 im Bereich der Profilierung 8 über 200° C, insbesondere 300 bis 400° C beträgt. Im Bereich der Anschlusskontaktfelder 6 am anderen Ende des Prägestempels 1 beträgt die Temperatur unter 40° C, so dass an den Kunststoff der Leiterplatte keine besonderen Anforderungen bezüglich der Temperaturresistenz erforderlich sind. Ein Heißprägestempel benötigt bei Anwendung des erfindungsgemäßen Chips (Prägestempels 1) keine externe Heizquelle und kann sehr präzise feinste Strukturen stempeln.

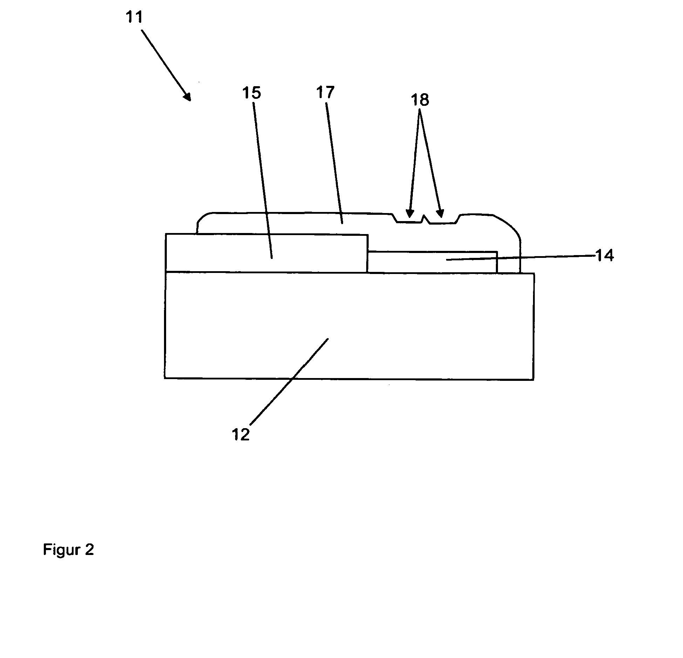

Figur 2 zeigt eine alternative Ausführungsform eines erfindungsgemäßen Prägestempels 11 in schematischer Querschnittansicht. Auf einem wärmeisolierenden 15 x 4 x 0,5 mm³ MgTiO₃ Substrat 12 wird in einer Hälfte eine Ir- oder Pt-Paste aufgebracht und zu einem mäanderförmigen 20 µm dicken Heizwiderstand 14 gebrannt. Auf den beiden elektrischen Enden des Heizwiderstands 14 wird je eine aus Silberpaste oder Kupferpaste gebrannte Leitung 15 angeschlossen. Auf der anderen Hälfte des Substrats 12 werden die Leitungen 15 am Substratende zu Kontaktfeldern verbreitert, um dort einen elektrischen Anschluss für den Prägestempel 11 anzuordnen, beispielsweise in Form von Anschlussdrähten (nicht gezeigt).

Die Leitungen 15 können, wie in Figur 2 gezeigt, dicker als der Heizwiderstand 14 sein, um den elektrischen Widerstand des Heizwiderstands 14 relativ zu dem der Leitungen 15 zu erhöhen. Dies muss jedoch nicht so sein. Der gleiche Effekt ergibt sich auch, wenn der Heizwiderstand 14 durch eine ausreichende Anzahl von Mäandern eine deutlich längere Stromleitung hat, als die Zuleitungen.

Der Verbindungsbereich der Anschlussdrähte an den Kontaktfeldern wird durch Einbrennen von Glaspaste zugentlastet. Auf den Heizwiderstand 14 und die Leitungen 15 werden verschiedene Glaspasten in Form eines Musters 17 oder einer Beschriftung 17 übereinander als Dickschichten gebrannt. Die Muster 17 weisen eine Profilierung 18 der Oberfläche im Bereich des Heizelements 14 auf. Die Glasschichten schützen den Heizwiderstand 14 und dessen Zuleitungen 15, insbesondere während des Heißprägevorgangs. Derartig bedrahtete Bauelemente nennt man auch Schichtwiderstände.

Die erfindungsgemäßen Prägestempel 1, 11 werden also durch Schichtwiderstände realisiert. Gerade hierin ist einer der besonderen Aspekte der Erfindung zu sehen, dass Schichtwiderstände zum Aufbau von Prägestempeln 1, 11 verwendet werden.

Die in der voranstehenden Beschreibung, sowie den Ansprüchen, Figuren und Ausführungsbeispielen offenbarten Merkmale der Erfindung können sowohl einzeln, als auch in jeder beliebigen Kombination für die Verwirklichung der Erfindung in ihren verschiedenen Ausführungsformen wesentlich sein.

### Bezugszeichenliste

- 1, 11: Prägestempel
- 2, 12: Substrat
- 3: Dünnschicht
- 4, 14: Heizwiderstand
- 5, 15: Leitung
- 6: Kontaktfeld
- 7, 17: elektrisch isolierende Schicht
- 8, 18: Profilierung

## Patentansprüche

1. Prägestempel zum Heißprägen eines Materials umfassend eine profilierte Prägeoberfläche (8, 18), wobei der Prägestempel (1, 11) zumindest ein wärmeisolierendes Substrat (2, 12) umfasst, auf dem eine elektrisch leitende Struktur (4, 5, 6, 14, 15) umfassend einen Heizwiderstand (4, 14) angeordnet ist, und dass die elektrisch leitende Struktur (4, 5, 6, 14, 15) mit einer elektrisch isolierenden Schicht (7, 17) abgedeckt ist, wobei die Oberfläche der elektrisch isolierenden Schicht (7, 17) die profilierte Prägeoberfläche (8, 18) umfasst und die elektrisch isolierende Schicht (7, 17) zumindest den Heizwiderstand (4, 14) abdeckt, so dass die elektrisch isolierende Schicht (7, 17) mit der Prägeoberfläche (8, 18) durch den Heizwiderstand (4, 14) elektrisch beheizbar ist und wobei das wärmeisolierende Substrat (2, 12) eine oxydische Keramik und/oder ein Metalloxid ist und das wärmeisolierende Substrat (2, 12) eine Wärmeleitfähigkeit kleiner als 5 W / (m K) hat.

2. Prägestempel nach Anspruch 1, **dadurch gekennzeichnet, dass** die elektrisch leitende Struktur (4, 5, 6, 14, 15) zwei Leitungen (5, 15) umfasst, über die der Heizwiderstand (4, 14) elektrisch kontaktierbar ist, wobei vorzugsweise die Leitungen (5, 15) einen größeren Leitungsquerschnitt als der Heizwiderstand (4, 14) aufweisen, besonders bevorzugt einen zumindest doppelt so großen Leitungsquerschnitt.

3. Prägestempel nach Anspruch 2, **dadurch gekennzeichnet, dass** die Leitungen (5, 15) zumindest bereichsweise oder im Wesentlichen von der elektrisch isolierenden Schicht (7, 17) bedeckt sind und/oder die Leitungen (5, 15) aus Kupfer und/oder Silber bestehen.

4. Prägestempel nach einem der vorangehenden Ansprüche, **dadurch gekennzeichnet, dass**
die elektrisch leitende Struktur (4, 5, 6, 14, 15) eine metallische Struktur (4, 5, 6, 14, 15) ist, insbesondere eine metallische Dickschicht ist, wobei bevorzugt der Heizwiderstand (4, 14) aus Platin oder Iridium besteht.

5. Prägestempel nach einem der vorangehenden Ansprüche, **dadurch gekennzeichnet, dass**
das wärmeisolierende Substrat (2, 12) Wärmeleitfähigkeit kleiner als 2 W / (m K) hat, besonders bevorzugt eine Wärmeleitfähigkeit kleiner als 1 W / (m K).

6. Prägestempel nach einem der vorangehenden Ansprüche, **dadurch gekennzeichnet, dass**
das wärmeisolierende Substrat (2, 12) ein Metalloxid eines drei- bis fünfwertigen Nebengruppenmetalls ist, besonders bevorzugt ein Titanat, eine Yttriumoxid stabilisierte Zirkonoxid-Keramik (YSZ) (2) oder eine MgTiO₃-Keramik (12).

7. Prägestempel nach einem der vorangehenden Ansprüche, **dadurch gekennzeichnet, dass**
zwischen dem wärmeisolierenden Substrat (2, 12), insbesondere dem YSZ-Substrat (2) und der elektrisch leitfähigen Struktur (4, 5, 6, 14, 15) eine keramische Dünnschicht (3) angeordnet ist, die die elektrisch leitfähige Struktur (4, 5, 6, 14, 15) von dem wärmeisolierenden Substrat (2, 12) elektrisch isoliert, wobei die keramische Dünnschicht (3) bevorzugt aus einem Metalloxid besteht, besonders bevorzugt aus einer oxydischen Keramik zwei- oder dreiwertiger Hauptgruppenmetalle, ganz besonders bevorzugt aus Aluminiumoxid.

8. Prägestempel nach einem der vorangehenden Ansprüche, **dadurch gekennzeichnet, dass**
die elektrisch isolierende Schicht (7, 17) aus Glas oder einer Glaskeramik besteht, die bevorzugt zwischen 1 µm und 500 µm dick ist, besonders bevorzugt zwischen 10 µm und 100 µm dick ist, ganz besonders bevorzugt 30 µm dick ist.

9. Prägestempel nach einem der vorangehenden Ansprüche, **dadurch gekennzeichnet, dass**
der Heizwiderstand (4, 14) mit zwei Anschlusskontaktfeldern (6) oder zwei Anschlusssteckern elektrisch verbunden ist, vorzugsweise an jeder Leitung (5, 15) ein Anschlusskontaktfeld (6) oder ein Anschlussstecker an dem vom Heizwiderstand (4, 14) gegenüberliegenden Ende der Leitungen (5, 15) angeordnet ist.

10. Prägestempel nach einem der vorangehenden Ansprüche, **dadurch gekennzeichnet, dass**
der Heizwiderstand (4, 14) die Hälfte bis ein Drittel der Breite der elektrisch leitenden Struktur (4, 5, 6, 14, 15) ausmacht und/oder der Heizwiderstand (4, 14) nach Art einer Spitze ausgebildet ist.

11. Verfahren zum Heißprägen eines Materials mit einem Prägestempel (1, 11) nach einem der vorangehenden Ansprüche, **dadurch gekennzeichnet, dass**
der Heizwiderstand (4, 14) auf eine Temperatur zwischen 100° C und 800° C, vorzugsweise zwischen 200° C und 600 C, besondersbevorzugt zwischen 300° C und 400° C geheizt wird.

12. Verfahren nach Anspruch 11, **dadurch gekennzeichnet, dass**
ein organisches Material zumindest bereichsweise bei einer Temperatur zwischen 100° C und 600° C im Bereich der profilierten Oberfläche (8,18) des Prägestempels (1, 11) zersetzt wird, insbesondere pyrolisiert und/oder oxidiert wird.

13. Verfahren nach Anspruch 11 oder 12, **dadurch gekennzeichnet, dass**
sich beim Heizen des Prägestempels (1, 11) ein Temperaturgradient einstellt, bei dem mehr als die Hälfte der Temperaturdifferenz zwischen der Temperatur im Bereich des Heizwiderstands (4, 14) und der Umgebungstemperatur, vorzugsweise der Raumtemperatur, im Bereich des Heizwiderstands (4, 14) abfällt, vorzugsweise mehr als 90%, so dass das dem Heizwiderstand (4, 14) gegenüberliegende Ende des Prägestempels (1, 11) eine Temperatur von unter 50°C aufweist, vorzugsweise eine Temperatur von unter 40° C.

14. Verfahren zur Herstellung eines Prägestempels nach einem der Ansprüche 1 bis 10, bei dem
A) ein wärmeisolierendes Substrat (2, 12) bereitgestellt wird, wobei das wärmeisolierende Substrat (2, 12) eine oxydische Keramik und/oder ein Metalloxid ist und das wärmeisolierende Substrat (2, 12) eine Wärmeleitfähigkeit kleiner als 5 W / (m K) hat,
B) auf dem wärmeisolierenden Substrat (2, 12) eine elektrisch leitende Struktur (4, 5, 6, 14, 15) umfassend einen Heizwiderstand (4, 14) aufgebracht wird, insbesondere mit einem Dickschicht-Verfahren, besonders bevorzugt aufgedruckt wird, und
C) die elektrisch leitende Struktur (4, 5, 6, 14, 15) zumindest bereichsweise mit einer elektrisch isolierenden Schicht (7, 17) mit einem Siebdruck-Verfahren oder einer Dickschicht-Technik abgedeckt wird.

15. Verfahren nach Anspruch 14, **dadurch gekennzeichnet, dass**
vor Schritt B) eine elektrisch isolierende Zwischenschicht (3) auf dem wärmeisolierenden Substrat (2, 12) aufgebracht wird, so dass bei Schritt B) die elektrisch leitende Struktur (4, 5, 6, 14, 15) auf der isolierenden Zwischenschicht (3) auf dem wärmeisolierenden Substrat (2, 12) aufgebracht wird, wobei die Zwischenschicht (3), vorzugsweise mit einem Dünnschicht-Verfahren, besonders bevorzugt mit PVD aufgebracht wird.

## Claims

1. A stamping die for hot stamping a material, comprising a profiled stamping surface (8, 18), wherein the stamping die (1, 11) comprises at least one thermally insulating substrate (2, 12) on which an electrically conducting structure (4, 5, 6, 14, 15) comprising a heating resistor (4, 14) is arranged, and the electrically conducting structure (4, 5, 6, 14, 15) is covered by an electrically insulating layer (7, 17), wherein the surface of the electrically insulating layer (7, 17) comprises the profiled stamping surface (8, 18) and the electrically insulating layer (7, 17) covers at least the heating resistor (4, 14), so that the electrically insulating layer (7, 17) comprising the stamping surface (8, 18) can be electrically heated by the heating resistor (4, 14), and wherein the thermally insulating substrate (2, 12) is an oxidic ceramic and/or a metal oxide and the thermally insulating substrate (2, 12) has a thermal conductivity of less than 5 W/(m K).

2. The stamping die according to claim 1, **characterized in that**
the electrically conducting structure (4, 5, 6, 14, 15) comprises two lines (5, 15), via which the heating resistor (4, 14) can be electrically contacted, wherein the lines (5, 15) preferably have a larger line cross-section than the heating resistor (4, 14), particularly preferably a line cross-section that is at least twice as large.

3. The stamping die according to claim 2, **characterized in that**
the lines (5, 15) are covered at least in regions or substantially by the electrically insulating layer (7, 17) and/or the lines (5, 15) are made of copper and/or silver.

4. A stamping die according to any one of the preceding claims, **characterized in that**
the electrically conducting structure (4, 5, 6, 14, 15) is a metal structure (4, 5, 6, 14, 15), in particular a metallic thick film, wherein the heating resistor (4, 14) is preferably made of platinum or iridium.

5. A stamping die according to any one of the preceding claims, **characterized in that**
the thermally insulating substrate (2, 12) has a thermal conductivity of less than 2 W/(m K), particularly preferably a thermal conductivity of less than 1 W/(m K).

6. A stamping die according to any one of the preceding claims, **characterized in that**
the thermally insulating substrate (2, 12) is a metal oxide of a trivalent to pentavalent transition metal, particularly preferably a titanate, an yttriastabilized zirconium oxide ceramic (YSZ) (2) or a MgTiO₃ ceramic (12).

7. A stamping die according to any one of the preceding claims, **characterized in that**
a thin ceramic film (3) is disposed between the thermally insulating substrate (2, 12), in particular the YSZ substrate (2), and the electrically conducting structure (4, 5, 6, 14, 15) the thin ceramic film electrically insulates the electrically conductive structure (4, 5, 6, 14, 15) from the thermally insulating substrate (2, 12), wherein the thin ceramic film (3) is preferably made of a metal oxide, particularly preferably made of an oxidic ceramic of bivalent or trivalent main group metals, and most particularly preferably made of aluminum oxide.

8. A stamping die according to any one of the preceding claims, **characterized in that**
the electrically insulating layer (7, 17) is made of glass or a glass ceramic, which preferably is between 1 µm and 500 µm thick, particularly preferably between 10 µm and 100 µm thick, and most particularly preferably 30 µm thick.

9. A stamping die according to any one of the preceding claims, **characterized in that**
the heating resistor (4, 14) is electrically connected to two connecting contact fields (6) or two connecting plugs, a connecting contact field (6) or a connecting plug preferably being disposed on each line (5, 15) at the end of the lines (5, 15) located opposite the heating resistor (4, 14).

10. A stamping die according to any one of the preceding claims, **characterized in that**
the heating resistor (4, 14) accounts for one half to one third of the width of the electrically conducting structure (4, 5, 6, 14, 15) and/or the heating resistor (4, 14) is formed in the manner of a tip.

11. A method for hot stamping a material using a stamping die (1, 11) according to any one of the preceding claims, **characterized in that**
the heating resistor (4, 14) is heated to a temperature between 100ºC and 800ºC, preferably between 200ºC and 600ºC, and particularly preferably between 300ºC and 400ºC.

12. The method according to claim 11, **characterized in that**
an organic material is decomposed, in particular pyrolized and/or oxidized, at least in regions at a temperature between 100ºC and 600ºC in the region of the profiled surface (8, 18) of the stamping die (1, 11).

13. The method according to claim 11 or 12, **characterized in that**
a temperature gradient develops during the heating of the stamping die (1, 11), in which more than half the temperature difference between the temperature in the region of the heating resistor (4, 14) and the ambient temperature, preferably room temperature, drops in the region of the heating resistor (4, 14), preferably more than 90%, so that the end of the stamping die (1, 11) located opposite the heating resistor (4, 14) has a temperature of less than 50ºC, and preferably a temperature of less than 40ºC.

14. A method for producing a stamping die according to any one of claims 1 to 10, wherein:
A) a thermally insulating substrate (2, 12) is provided, wherein the thermally insulating substrate (2, 12) is an oxidic ceramic and/or a metal oxide and the thermally insulating substrate (2, 12) has a thermal conductivity of less than 5 W/(m K);
B) an electrically conducting structure (4, 5, 6, 14, 15) comprising a heating resistor (4, 14) is applied to the thermally insulating substrate (2, 12), in particular using a thick film method, particularly preferably by printing; and
C) the electrically conducting structure (4, 5, 6, 14, 15) is covered at least in regions by an electrically insulating layer (7, 17) using a screen-printing method or a thick-film technique.

15. The method according to claim 14, **characterized in that**
prior to step B), an electrically insulating intermediate layer (3) is applied to the thermally insulating substrate (2, 12), so that, in step B), the electrically conducting structure (4, 5, 6, 14, 15) is applied to the insulating intermediate layer (3) on the thermally insulating substrate (2, 12), wherein the intermediate layer (3) is preferably applied using a thin-film method, particularly preferably using PVD.

## Revendications

1. Poinçon d'estampage pour l'estampage à chaud d'un matériau, comprenant une surface d'estampage profilée (8, 18), le poinçon d'estampage (1, 11) comprenant au moins un substrat thermo-isolant (2, 12) sur lequel est agencée une structure électriquement conductrice (4, 5, 6, 14, 15) comprenant une résistance chauffante (4, 14), et la structure électriquement conductrice (4, 5, 6, 14, 15) étant recouverte d'une couche électriquement isolante (7, 17), la surface de la couche électriquement isolante (7, 17) comprenant la surface d'estampage profilée (8, 18), et la couche électriquement isolante (7, 17) recouvrant au moins la résistance chauffante (4, 14) de manière à ce que la couche électriquement isolante (7, 17) avec la surface d'estampage (8, 18) puisse être chauffée électriquement par la résistance chauffante (4, 14), et le substrat thermo-isolant (2, 12) étant une céramique en oxyde et/ou un oxyde de métal, et le substrat thermo-isolant (2, 12) présentant une conductivité thermique inférieure à 5 W / (m K).

2. Poinçon d'estampage selon la revendication 1, **caractérisé en ce que** la structure électriquement conductrice (4, 5, 6, 14, 15) comprend deux lignes (5, 15) par lesquelles la résistance chauffante (4, 14) peut être mise en contact électrique, les lignes (5, 15) présentant de préférence une plus grande section transversale de ligne que la résistance chauffante (4, 14), et de façon particulièrement préférée, une section transversale de ligne au moins deux fois plus grande.

3. Poinçon d'estampage selon la revendication 2, **caractérisé en ce que** les lignes (5, 15) sont au moins par endroits ou essentiellement recouvertes par la couche électriquement isolante (7, 17), et/ou **en ce que** les lignes (5, 15) sont constituées de cuivre et/ou d'argent.

4. Poinçon d'estampage selon l'une des revendications précédentes, **caractérisé en ce que**
la structure électriquement conductrice (4, 5, 6, 14, 15) est une structure métallique (4, 5, 6, 14, 15), en particulier une couche métallique épaisse, la résistance chauffante (4, 14) étant de préférence constituée de platine ou d'iridium.

5. Poinçon d'estampage selon l'une des revendications précédentes, **caractérisé en ce que**
le substrat thermo-isolant (2, 12) présente une conductivité thermique inférieure à 2 W / (m K), et de façon particulièrement préférée une conductivité thermique inférieure à 1 W / (m K).

6. Poinçon d'estampage selon l'une des revendications précédentes, **caractérisé en ce que**
le substrat thermo-isolant (2, 12) est un oxyde de métal d'un métal de groupe secondaire trivalent ou pentavalent, de façon particulièrement préférée un titane, une céramique en oxyde de zirconium stabilisé à l'oxyde d'yttrium (YSZ) (2) ou une céramique MgTiO3 (12).

7. Poinçon d'estampage selon l'une des revendications précédentes, **caractérisé en ce que**
entre le substrat thermo-isolant (2, 12), en particulier le substrat YSZ (2), et la structure électriquement conductrice (4, 5, 6, 14, 15), il est prévu une couche de céramique mince (3) isolant électriquement la structure électriquement conductrice (4, 5, 6, 14, 15) par rapport au substrat thermo-isolant (2, 12), la couche de céramique mince (3) étant de préférence constituée d'un oxyde de métal, de façon particulièrement préférée d'une céramique en oxyde de métaux de groupe secondaire divalents ou trivalents, et mieux, d'oxyde d'aluminium.

8. Poinçon d'estampage selon l'une des revendications précédentes, **caractérisé en ce que**
la couche électriquement isolante (7, 17) est constituée de verre ou d'une céramique de verre, présentant de préférence une épaisseur entre 1 µm et 500 µm, de façon particulièrement préférée une épaisseur entre 10 µm et 100 µm, et mieux, une épaisseur de 30 µm.

9. Poinçon d'estampage selon l'une des revendications précédentes, **caractérisé en ce que**
la résistance chauffante (4, 14) est électriquement reliée à deux champs de contact de connexion (6) ou deux connecteurs, un champ de contact de connexion (6) ou un connecteur étant de préférence agencé sur chaque ligne (5, 15), à l'extrémité des lignes (5, 15) qui est opposée à la résistance chauffante (4, 14).

10. Poinçon d'estampage selon l'une des revendications précédentes, **caractérisé en ce que**
la résistance chauffante (4, 14) représente entre la moitié et un tiers de la largeur de la structure électriquement conductrice (4, 5, 6, 14, 15), et/ou la résistance chauffante (4, 14) est conçue comme une pointe.

11. Procédé pour l'estampage à chaud d'un matériau avec un poinçon d'estampage (1, 11) selon l'une des revendications précédentes, **caractérisé en ce que** la résistance chauffante (4, 14) est chauffée à une température entre 100° C et 800° C, de préférence entre 200° C et 600° C, de façon particulièrement préférée entre 300° Cet 400° C.

12. Procédé selon la revendication 11, **caractérisé en ce qu'**un matériau organique est décomposé au moins par endroits à une température entre 100° C et 600° C dans la région de la surface profilée (8, 18) du poinçon d'estampage (1, 11), en particulier pyrolysé et/ou oxydé.

13. Procédé selon la revendication 11 ou 12, **caractérisé en ce que** lors du chauffage du poinçon d'estampage (1, 11), il s'établit un gradient de température avec lequel plus de la moitié de la différence de température entre la température dans la région de la résistance chauffante (4, 14) et la température environnante, de préférence la température ambiante, chute dans la région de la résistance chauffante (4, 14), de préférence plus de 90%, de sorte que l'extrémité du poinçon d'estampage (1, 11) qui est opposée à la résistance chauffante (4, 14) présente une température inférieure à 50° C, de préférence une température hférieure à 40° C.

14. Procédé pour la fabrication d'un poinçon d'estampage selon l'une des revendications 1 à 10, dans lequel
A) un substrat thermo-isolant (2, 12) est préparé, le substrat thermo-isolant (2, 12) étant une céramique en oxyde et/ou un oxyde de métal, et le substrat thermo-isolant (2, 12) présentant une conductivité thermique inférieure à 5 W / (m K),
B) une structure électriquement conductrice (4, 5, 6, 14, 15) comprenant une résistance chauffante (4, 14) est appliquée sur le substrat thermo-isolant (2, 12), de façon particulièrement préférée imprimée, en particulier à l'aide d'un procédé à couche épaisse, et
C) la structure électriquement conductrice (4, 5, 6, 14, 15) est au moins par endroits recouverte d'une couche électriquement isolante (7, 17) à l'aide d'un procédé de sérigraphie ou d'une technique de couche épaisse.

15. Procédé selon la revendication 14, **caractérisé en ce que** avant l'étape B), une couche intermédiaire (3) électriquement isolante est appliquée sur le substrat thermo-isolant (2, 12), de sorte qu'à l'étape B), la structure électriquement conductrice (4, 5, 6, 14, 15) est appliquée sur la couche intermédiaire isolante (3) sur le substrat thermo-isolant (2, 12), la couche intermédiaire (3) étant appliquée de façon particulièrement préférée avec du PVD, de préférence à l'aide d'un procédé de couche mince.
